(19) Europäisches Patentamt
European Patent Office
Office européen des brevets

(11) **EP 3 113 306 B1**

## (12) EUROPEAN PATENT SPECIFICATION

(45) Date of publication and mention
of the grant of the patent:
**22.04.2020 Bulletin 2020/17**

(21) Application number: **15174504.9**

(22) Date of filing: **30.06.2015**

(51) Int Cl.:
*H01S 5/34* *(2006.01)*  *H01L 31/0352* *(2006.01)*
*G02B 6/122* *(2006.01)*  *G02B 6/126* *(2006.01)*
*H01L 31/105* *(2006.01)*

(54) **PHOTON SOURCE**

PHOTONENQUELLE

SOURCE DE PHOTONS

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**04.01.2017 Bulletin 2017/01**

(73) Proprietor: **Hitachi, Ltd.
Tokyo (JP)**

(72) Inventor: **RAMSAY, Andrew
Cambridge, CB3 0HE (GB)**

(74) Representative: **Piotrowicz, Pawel Jan Andrzej
Venner Shipley LLP
Byron House
Cambridge Business Park
Cowley Road
Cambridge CB4 0WZ (GB)**

(56) References cited:
**GB-A- 2 443 220**

• **R. J. COLES ET AL: "Waveguide-coupled
photonic crystal cavity for quantum dot spin
readout", OPTICS EXPRESS, vol. 22, no. 3, 28
January 2014 (2014-01-28), page 2376,
XP055233475, DOI: 10.1364/OE.22.002376**
• **C. BENTHAM ET AL: "On-chip electrically
controlled routing of photons from a single
quantum dot", APPLIED PHYSICS LETTERS, vol.
106, no. 22, 1 June 2015 (2015-06-01) , page
221101, XP055233522, 2 Huntington Quadrangle,
Melville, NY 11747 ISSN: 0003-6951, DOI:
10.1063/1.4922041**

**Description**

**Field of the Invention**

The present invention relates to a photon source, in particular a single-photon source.

**Background**

A quantum dot can be used as the basis of a single-photon source. For example, US 6 728 281 B1 describes a quantum-dot photon turnstile device in which electrons and holes are controllably injected into a quantum dot, where they combine to form photons. Similar devices are described in US 6 956 330 B2, C. Santori et al.: "Triggered single photons from a quantum dot", Physical Review Letters, volume 86, page 1502 (2001), Z. Yuan et al: "Electrically Driven Single-Photon Source", Science, volume 295, page 102 (2002), US 2003/0127608 A1 and US 7 019 333 B1.

A considerable amount of effort has been directed to collecting photons more efficiently so as to enhance the brightness of the source. In the main, this effort has focussed on the use of cavities, for example, as described in T. Heindel et al.: "Electrically driven quantum dot-micropillar single photon source with 34% overall efficiency", Applied Physics Letters, volume 96, page 011107 (2010) or employing tapered nanowires and the like to direct emission in a particular free-space direction as described, for example, in M. T. Borgstrom et al.: "Optically Bright Quantum Dots in Single Nanowires", Nano Letters, volume 5, page 1439 (2005).

However, integrating the quantum dot into a waveguide can increase brightness by helping to avoid in-coupling losses. Furthermore, it becomes easier to match quantum dot emission energy to photonic structure since the Purcell enhancement in emission rate is broadband thereby increasing brightness still further. Examples of these arrangements are described in M. T. Borgstrom et al. ibid., A. Laucht et al.: "A Waveguide-Coupled On-Chip Single-Photon Source", Physical Review X, volume 2, page 011014 (2012), A. Laucht et al.: "Broadband Purcell enhanced emission dynamics of quantum dots in linear photonic crystal waveguides", Journal of Applied Physics, volume 112, page 093520 (2012) and T. Lund-Hansen: "Experimental Realization of Highly Efficient Broadband Coupling of Single Quantum Dots to a Photonic Crystal Waveguide", Physical Review Letters, volume 101, page 113903 (2008). Reference is also made to P. Stepanov et al.: "Quantum dot spontaneous emission control in a ridge waveguide", Applied Physics Letters, volume 106, page 041112 (2015).

Although these arrangements can exhibit β-factors (i.e. high collection efficiencies) in excess of 85%, losses due to pumping are not considered or discussed.

**Summary**

According to a first aspect of the present invention there is provided a photon source. The photon source, preferably a single-photon source, comprises a quantum dot embedded in an optical waveguide. The quantum dot has first and second bright neutral-exciton spin states having first and second orthogonal optical dipoles respectively. The optical waveguide lies in a plane, comprises crystalline semiconductor material having first and second in-plane crystal axes and has a waveguide mode. The source is configured to couple the first and second spin states to the waveguide mode. The waveguide is orientated such that the polarization of the waveguide mode is misaligned with the first and second optical dipoles (which are aligned with the first and second in-plane crystal axes), i.e. neither of the first and second optical dipoles is aligned with the polarization of the waveguide mode.

Thus, the probability of photon emission from the quantum dot resulting from electrical or non-resonant (or "incoherent") optical excitation (i.e. brightness of the source) can be increased by activating both states even though the coupling strength of an individual state to the waveguide mode could be higher.

The quantum dot, in response to recombination of an electron and hole therein, emits a photon in plane having given polarization.

The waveguide is preferably a single-mode waveguide.

The waveguide may be orientated at an angle, $\theta$, which bisects the first and second in-plane crystal axes. The waveguide may be orientated such that one of the first and second optical dipoles is aligned with one of the first and second in-plane crystal axes. The waveguide may be strained in an in-plane direction which is misaligned with the first and second in-plane crystal axes. Thus, first and second anisotropic axes which are usually defined by the first and second crystal axes are re-orientated. The direction of strain may be orientated at an angle, $\theta$, which bisects the first and second in-plane crystal axes. The angle may be 45 ° when the first and second crystal axes are perpendicular (i.e. at 90 °).

Strain may be induced during growth. Alternatively, the photon source may comprise a stressor, for example a piezoelectric stressor, configured to apply strain to the waveguide in a direction which is misaligned with the first and second in-plane crystal axes. The stressor may be bonded to the waveguide.

The photon source may comprise a magnetic field source configured to apply an out-of-plane magnetic field to the quantum dot such that the optical dipoles are circularly-polarized.

The photon source may further comprise a circuit or optical source configured to charge the quantum dot with an electron such that the first and second negative-exciton spin states having circularly -polarised optical dipoles are coupled to the waveguide mode.

The quantum dot may be disposed at a position in the waveguide where the polarization of the waveguide mode is misaligned with the respective optical dipoles of the first and second spin states of the quantum dot.

The quantum dot may comprise a first region of a first semiconductor material disposed in a second region of a second, different semiconductor material, the first region being sufficiently small to exhibit zero-dimensional confinement. Herein, such a quantum dot is referred to as an "engineered quantum dot".

The quantum dot may comprise a dopant atom or molecule disposed in a region of undoped semiconductor material. Herein, such a quantum dot is referred to as a "dopant quantum dot".

The waveguide may comprise a photonic crystal. The waveguide may comprise a photonic wire.

According to a second aspect of the present invention there is provided apparatus comprising the single-photon source and a laser configured to optically excite the quantum dot.

According to a third aspect of the present invention there is provided apparatus comprising the single-photon source circuit configured to electrically excite the quantum dot.

## Brief Description of the Drawings

Certain embodiments of the present invention will now be described, by way of example, with reference to the accompanying drawings, in which:

Figure 1 illustrates pumping losses for a single-photon source comprising a quantum dot and an optical waveguide which is aligned along a crystal axis;

Figure 2 illustrates pumping losses for a single-photon source comprising a quantum dot and waveguide which is orientated at 45° with respect to a crystal axis in accordance with the present invention;

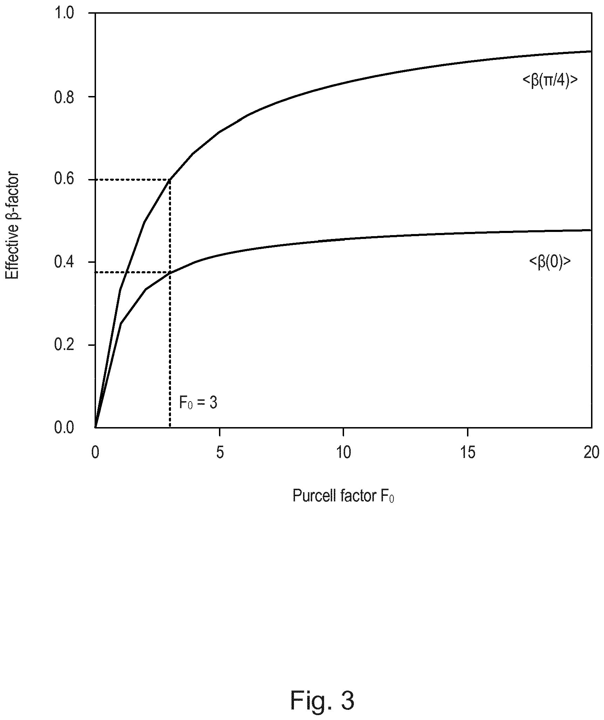

Figure 3 show plots of effective collection efficiency, $\beta$, against Purcell factor, $F_o$, for a pair of orthogonal dipoles aligned (i) along the waveguide or (ii) at angle of 45 degrees to the waveguide;

Figure 4 is a plan view of a single-photon comprising a quantum dot and an optical waveguide in the form of photonic crystal line defect waveguide;

Figure 5 is a cross-section view taken through the waveguide taken along the line A-A' in Figure 4;

Figures 6 a plan view of a portion of a photonic crystal line defect waveguide illustrating a position at which the Purcell factor is at a maximum and polarization is linearly polarized and a C-point at which Purcell factor is not at a maximum and polarization is circularly polarized;

Figure 7 is a plan view of a portion of a photonic crystal glided-plane waveguide illustrating a C-point having a high value of Purcell factor;

Figure 8 is a plan view of a single-photon comprising a quantum dot and an optical waveguide in the form of photonic wire;

Figure 9 is a cross-section view taken through the waveguide taken along the line B-B' in Figure 8;

Figure 11 schematically illustrates applying strain diagonally across a single-photon source;

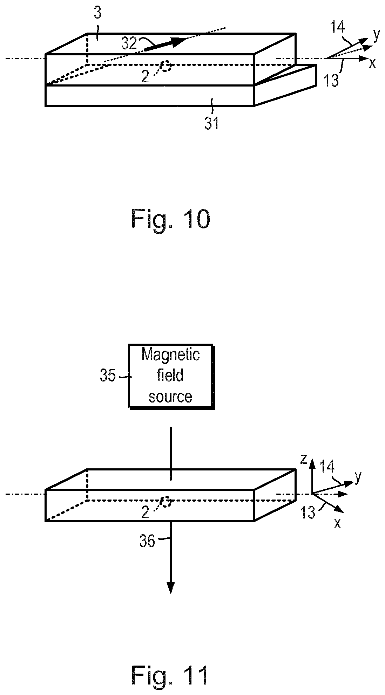

Figure 11 schematically illustrates applying an out-of plane magnetic field to a single-photon source;

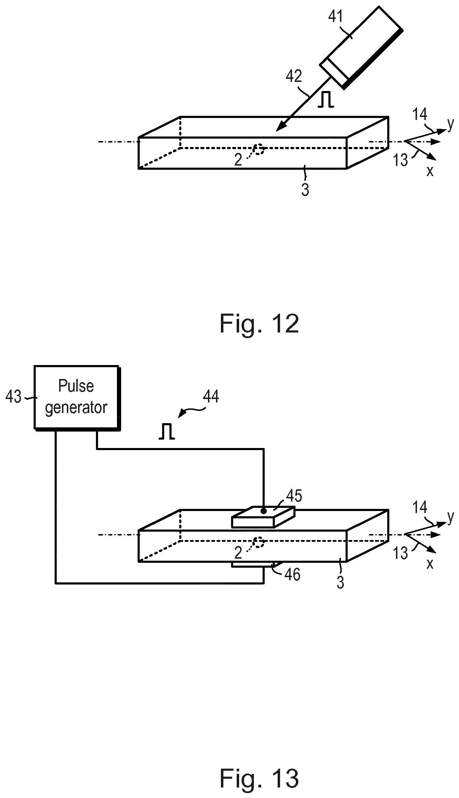

Figure 12 is a schematic diagram of a system for optically-exciting a quantum dot; and

Figure 13 is a schematic diagram of a system for electrically-exciting a quantum dot

## Detailed Description of Certain Embodiments

In the following, like part are denoted by like reference numerals.

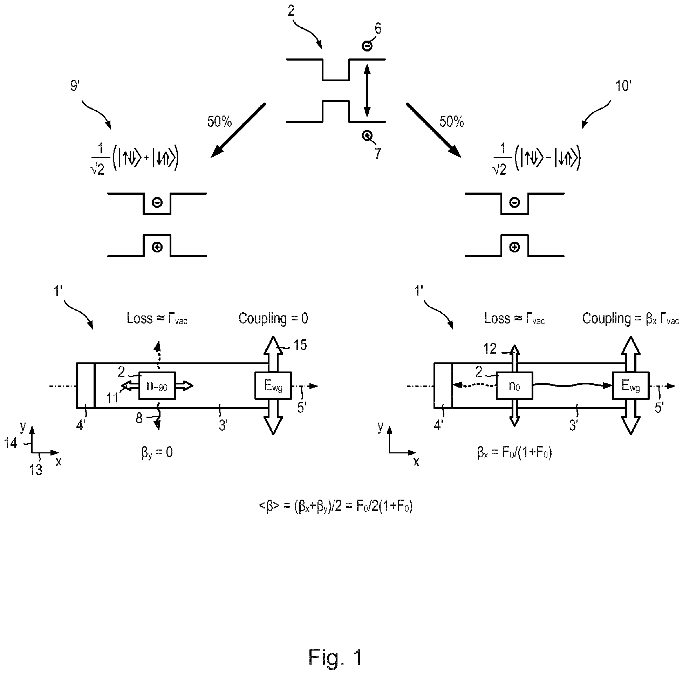

Referring to Figure 1, a single photon source 1' is shown which is useful for understanding the invention. The single photon source 1 comprises a quantum dot 2 embedded in an optical waveguide 3' having a mirror 4' at one end and running along a direction 5'.

An electron-hole pair 6, 7 is added to the quantum dot 2 by, for example, electrical injection or above band-gap excitation with a laser 41 (Figure 13). When the electron-hole pair 6, 7 recombines, a single photon 8 is emitted. The single photon 8 can be emitted into, and travels along, the waveguide 3' or is lost.

For a bright neutral-exciton state, there are two possible spin states 9', 10'. Due to electron-hole exchange interaction and a small asymmetry in the quantum dot 2, these states are separated in energy by a fine structure splitting of a few micro electron-volts and couple to linearly-polarized light in the sample plane, i.e. the x-y plane. The optical dipoles 11, 12 of the bright neutral exciton align with the crystal axes 13, 14, i.e. along the x-axis (i.e. parallel to the waveguide 3') or along y-axis (i.e. perpendicular to the waveguide 3'). Light is a transverse wave and a waveguide mode 15 propagating along the y-axis is linearly x-polarized at the centre of the waveguide where the coupling to the quantum dot is strongest.

In the case of a parallel optical dipole 11, the polarization of the emitted light 8 is orthogonal to the waveguide mode 15 and the single photon 8 is lost to the vacuum. In the case of perpendicular optical dipole 12, the polarization of the emitted photon is 8 parallel to the waveguide mode 15, and the photon 5 is maximally coupled to the waveguide mode 15. However, since non-resonant pumping populates both optical dipole states, the overall maximum brightness of the source is 50%.

The probability that a photon 8 emitted by an optical dipole oriented along a vector direction, **n,** is given by the $\beta$ factor, as described in V. S. C. Manga Rao and S. Hughes: "Single quantum-dot Purcell factor and $\beta$ factor in a photonic crystal waveguide", Physical Review B, volume 75, page 205437 (2007), namely:

$$\beta = \Gamma_{wg}\ (\Gamma_{wg} + \Gamma_{vac}) = F(1+F)^{-1} \qquad\qquad (1)$$

where $\Gamma_{wg}$ is the rate of radiative decay into the waveguide mode, $\Gamma_{vac}$ is the rate of decay of the dipole in vacuum and F is the Purcell factor. $\Gamma_{wg} = F\ \Gamma_{vac}$.

The Purcell factor, F, of a dipole positioned at point, **r,** aligned along **n,** coupled to a waveguide mode with wave vector **k,** frequency $\omega$, and Bloch mode of unit vector $\mathbf{E(k(\omega),r)}$ is given by:

$$F = F_0 |\mathbf{E(k(\omega),r).n)}\ |2 = F_0 \cos^2\theta \qquad\qquad (2)$$

Where $F_0$ is a maximum Purcell factor, $\mathbf{n} = \cos\theta\ \mathbf{x} + \sin\theta\ \mathbf{y}$ and $\mathbf{E(k(\omega),r)} = \mathbf{x}$.

In the case of incoherent pumping, both dipoles 11, 12 are equally populated with a probability of 50%. The effective $\beta$ factor for a pair of dipoles 11, 12 aligned along the usual directions of $\theta = 0$ and $\pi/2$ is given by:

$$\langle\beta(0)\rangle = (\beta(0) + \beta(\pi/2))/2 = F_0/(2(1+F_0)) < 1/2 \qquad\qquad (3\text{-}1)$$

For a pair of dipoles 11, 12 oriented at 45° to the waveguide direction, the effective $\beta$ factor is:

$$\langle\beta(\pi/4)\rangle = (\beta(+\pi/4) + \beta(-\pi/4))/2 = F_0/(2+F_0) < 1 \qquad\qquad (3\text{-}2)$$

Here, the Purcell factor is reduced by a factor of 2. However, the average $\beta$ factor is enhanced since both dipoles can now couple to the waveguide. For large Purcell factors, close to 100% collection efficiency can be achieved.

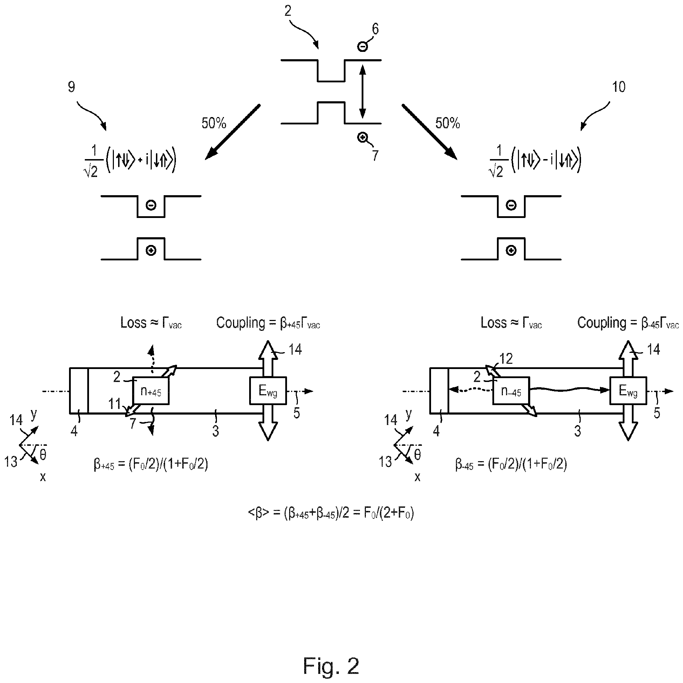

Referring to Figure 2, a single photon source 1 is shown in accordance with the present invention. The single photon source 1 comprises a quantum dot 2 embedded in an elongate optical waveguide 3 having a mirror 4 at one end running along a direction 5. For a bright neutral-exciton state, there are two possible spin states 9, 10. The optical waveguide 3 is orientated at 45° to the crystal axes 13, 14.

The brightness of a single photon source 1 can be doubled by orienting the exciton dipoles 11, 12 with respect to the waveguide mode 12.

In both cases, the optical dipole 11, 12 is misaligned with respect to the polarization of the waveguide mode 15. The emitted photon 8 is coupled to the waveguide with a coupling strength that is half of the maximum possible value. However, non-resonant pumping populates both optical dipole states and both states are now effectively coupled to the waveguide and so the overall brightness of the source can be as high as 100%.

Referring also to Figure 2, a relatively modest Purcell factor of 3 is enough to achieve an effective $\beta$ factor of 60% when the dipoles are oriented at 45° to the waveguide compared with an effective $\beta$ factor of 38% compared to when the dipoles are aligned along the waveguide.

Excitation of the neutral exciton can be achieved with non-polarized laser. Although resonantly-exciting the neutral exciton with a polarized laser (rather than populating the exciton spin states at random) can be used to exclusively populate the exciton spin that couples to the waveguide mode and so avoid losses due to pumping of the uncoupled dipole, resonant optical pumping can have drawbacks. First, scattering of the pump laser can result in a strong background signal at the same wavelength as the single photon source. Secondly, the scheme requires a laser of a specific wavelength, adding to the complexity and cost of such a device.

Enhancement of brightness of a photon source, such as a single-photon source, can be realized in a number of different ways which involves misaligning polarization of the quantum dot 2 and polarization of the waveguide 3 so that both states are coupled into the waveguide as opposed to just one of the states:

1. Alignment of waveguides

As explained earlier, by aligning the waveguide 3 at 45° to the crystal axes 13, 14, the optical dipoles 11, 12 of a neutral exciton transition 9, 10 will be coupled to the waveguide mode 15.

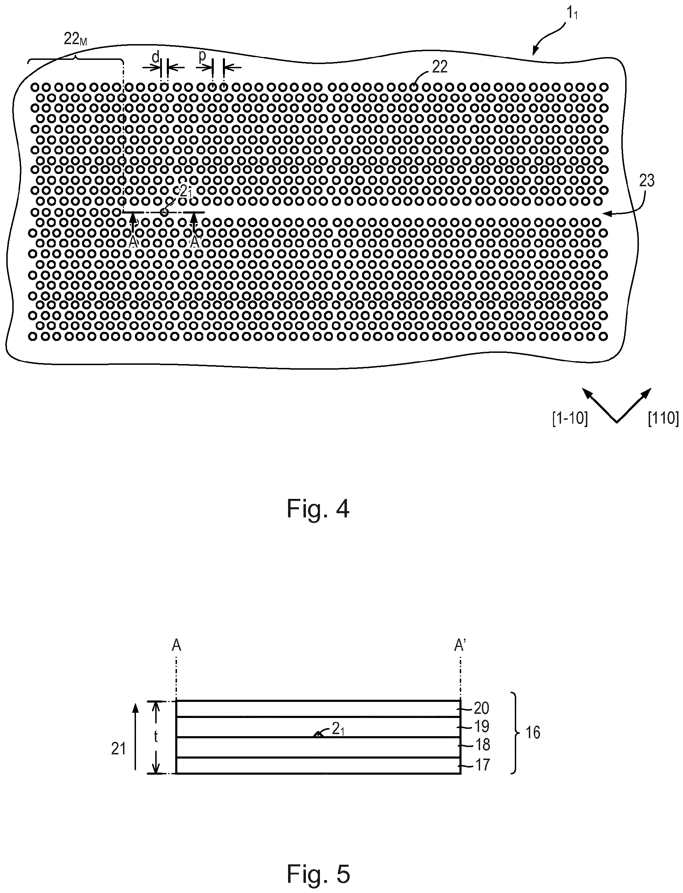

Referring to Figures 4 and 5, a first optical source $1_1$ is shown which comprises a quantum dot $2_1$ and a waveguide $3_1$.

The quantum dot $2_1$ may take the form of a self-assembled island of indium gallium arsenide (InGaAs) embedded in a suspended stacked layer structure 16 (or "membrane") which comprises a layer 17 of n-type gallium arsenide (n-GaAs), first and second layers of 18, 19 of undoped gallium arsenide (i-GaAs) and a layer 20 of p-type gallium arsenide (p-GaAs). The membrane 16 has a thickness of about 200 nm and is formed by removing an $Al_{0.7}Ga_{0.3}As$ sacrificial layer (not shown) lying under the n-GaAs layer 17. The suspended membrane 16 provides optical confinement in a vertical direction 21.

The quantum dot $2_1$ is one of a number of quantum dots (not shown) formed in the middle of the membrane 16 between the first and second i-GaAs 18, 19.

For devices using electrical carrier injection, an n-i-p doping profile is used to form a photodiode. Under forward bias, electrons and holes are injected into the quantum dot $2_1$, where they recombine and emit a photon preferentially into the waveguide mode due to the Purcell effect. The diode structure can also be used to charge the quantum dot. In this way, one can also use the emission of the charged exciton with an isotropic optical dipole.

The waveguide $3_1$ takes the form of a photonic crystal line defect waveguide. The waveguide 31 is orientated at 45° to the crystal axes [1-10] and [110].

The waveguide $3_1$ comprises a lattice of air holes 22 passing through the membrane 16 having a line defect 23. Holes $22_M$ to one side of the end of the waveguide $3_1$ (to the left of the end of lattice defect in Figure 4) form a mirror to direct the emitted photon 8 in the other direction (to the right in Figure 4).

The diameter, d, and pitch, p, of the holes 22 depends on the wavelength of light and on the refractive index, n, of the semiconductor material. For light having a wavelength of 912 nm and GaAs, the thickness, t, of the membrane is 180 nm, the diameter, d, of the holes 22 is 142 nm and the pitch, p, of the holes 22 is 240 nm.

The waveguide $3_1$ is positioned around the quantum dot $2_1$ using a registration technique, for example, as described in Lee et al.: "Cryogenic two-photon laser photolithography with SU-8", Applied Physics Letters, volume 88, page 143123 (2006).

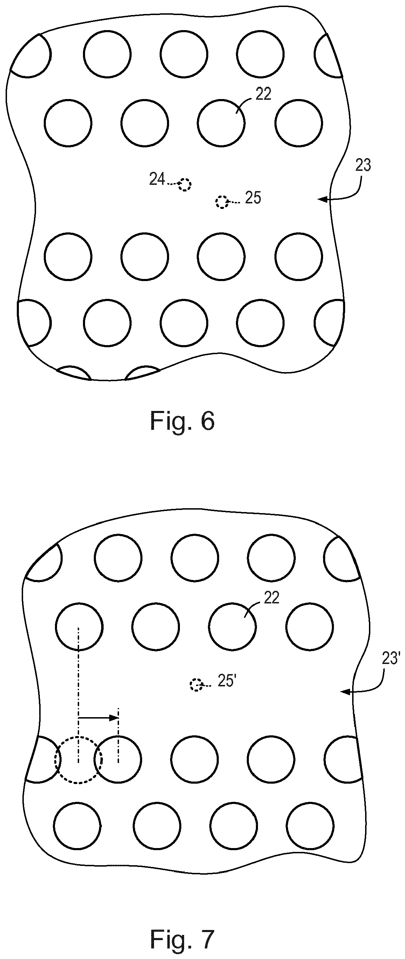

Referring to Figure 6, a more detailed view of part of the photonic crystal waveguide $3_1$ is shown.

Polarization of the waveguide modes is sensitive to position. A first point 24 indicates the point (in x-y) where the Purcell factor is a maximum and polarization is linearly polarized. A second point 25 indicates the C-point, the point (in x-y) where the polarization of the waveguide mode is circularly polarized, but where the Purcell factor is reduced.

If the quantum dot is positioned at the first point 24, higher brightness is achieved by misaligning the crystal-axes, i.e. by aligning the waveguide at 45° to the crystal axes [1-10] and [110].

Activation of both optical dipoles of the bright-exciton can also be achieved without misaligning the waveguide direction with respect to the crystal-axes, by positioning the quantum dot at the second point 25. At the C-point 25, the waveguide mode is circularly polarized and couples to both optical dipoles. This approach works less well since the Purcell factor is smaller at the C-point 25, compared to the first point 24.

Referring to Figure 7, a detailed view of part of a glided-plane photonic crystal waveguide is shown.

The polarization properties of the waveguide mode can be engineered, as described in I. Sollner et al.: "Deterministic photon-emitter coupling in chiral photonic circuits", ArXiv, 1406.4295 (2014).

As shown in Figure 7, the lattice below the waveguide 23' is shifted by one half period. This shifts the C-point 25' to the centre of the waveguide where the Purcell factor is stronger.

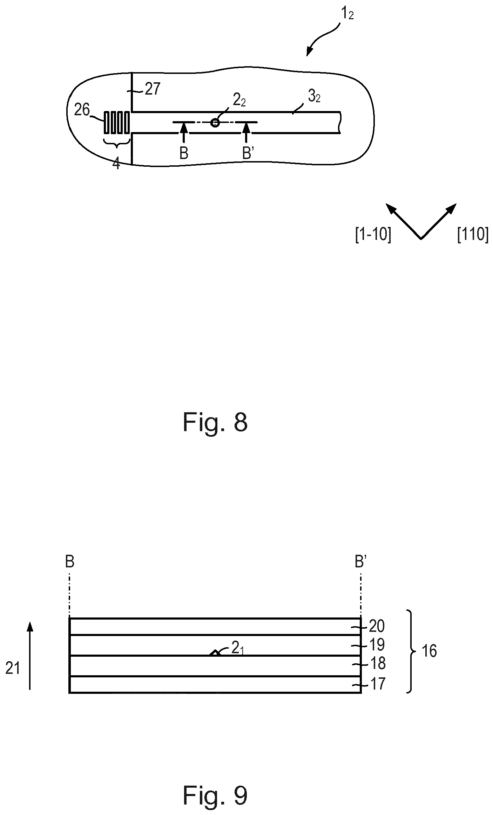

Referring to Figures 8 and 9, a second optical source $1_2$ is shown which comprises a quantum dot $2_2$ and a waveguide $3_3$.

The second optical source 12 is similar to the first optical source $1_1$ except that, rather than using a photonic crystal, a suspended photonic wire $3_2$ is used as a waveguide. The wire has cross-sectional dimensions of 200 × 200 nm. A grating structure 26 comprising a set of holes formed in a mesa 27 from which the wire extends is used as a mirror 4.

Compared to a photonic crystal, the Purcell factor for photonic wire is lower. However, the polarization structure of the waveguide modes is simpler and so there is a greater degree of freedom in positioning the quantum dot with respect to the waveguide

A suspended structure need not be used. For example, a ridge waveguide can be used.

## 2. Application of strain

Referring to Figure 10, a piezoelectric stressor 31 can be used to apply stress 32 across a waveguide 3' which is aligned with one of the crystal axes 13, 14. The stressor 31, which may comprises a slab of piezoelectric material having electrical contacts (not shown), is orientated at an angle, e.g. 45°, between the crystal axes 13, 14.

Under normal conditions, the crystal axes define an anisotropy and the optical dipoles of the neutral exciton transition are aligned along the crystal axes. However, by straining the device at 45° to the waveguide, the anisotropy axes are redefined aligning the optical dipoles at 45° to the waveguide.

## 3. Application of small magnetic field

Referring to Figure 11, a magnetic field source 35 can be used to apply an out-of-plane magnetic field 36, e.g. parallel to the z-axis.

By applying an out-of-plane magnetic field to the device, the spin of the energy eigenstates of the electron-hole pair will align along the magnetic field and couple to circularly polarized light, where $\mathbf{n} = (\mathbf{x} \pm i\mathbf{y})/\sqrt{2}$, also leading to an effective β-factor of $\langle\beta\rangle = F_o /(2+F_o)$.

## 4. Using charged quantum dot

In the case of the neutral exciton, the electron-hole exchange interaction couples the $M=\pm1$ spin-z states resulting in two dipoles that couple to linearly polarized light separated by a fine-structure splitting of a few micro electron-volts. If the quantum dot is charged with a single electron, the photon is generated by recombination of a charged exciton. The spin of the negative exciton is defined by the hole spin, since the two electrons have opposite spin, and therefore there is no exchange interaction. As such the energy eigenstates will couple to circularly polarized light, and hence both spin-states will couple to the waveguide.

## 5. Positioning the quantum dot in a photonic crystal line defect cavity

In a photonic crystal waveguide, the polarization of the Bloch mode varies in space, and for some positions the polarization has some longitudinal component. If the quantum dot is positioned at a spot where the polarization of the Bloch-mode couples to both dipoles of the neutral exciton, then similar improvements in the effective β factor would be observed.

In all such devices, a mirror can used to direct the light into a forward propagating waveguide mode.

## Electrical- and optical-excitation systems

Referring to Figure 12, a laser 41 can be used to illuminate the quantum dot 2 with a pulse of light 42 to generate an exciton.

Referring to Figure 13, an electrical pulse generator 43 can be used to apply a pulse 44 via contact regions 45, 46, e.g. p- and n-type regions 45, 46 respectively which sandwich an intrinsic semiconductor region providing the waveguide 3.

A single-photon source as hereinbefore described can be used in a linear optics quantum computing device, in a quantum communication system and/or in a spectroscopic system.

It will be appreciated that many modifications may be made to the embodiments hereinbefore described without departing from the scope of the appended claims.

For example, the source may be two-photon source. The source may be quantum-dot laser.

## Claims

1. A photon source (1) comprising a quantum dot (2) embedded in an optical waveguide (3), wherein the quantum dot has first and second bright neutral-exciton spin states (9, 10) having first and second orthogonal optical dipoles (11, 12) respectively and wherein the optical waveguide lies in a plane, comprises crystalline semiconductor material having first and second in-plane crystal axes (13, 14) and has a waveguide mode (15) **characterised in that** the source is configured to couple the first and second spin states to the waveguide mode, wherein the waveguide (3) is orientated such that the polarization of the waveguide mode is misaligned with the first and second optical dipoles (11, 12).

**2.** A photon source (1) according to claim 2, wherein the waveguide (3) is orientated at an angle which bisects the first and second in-plane crystal axes (13, 14).

**3.** A photon source (1) according to claim 1 or 2, wherein the waveguide (3) is orientated such that one of the first and second optical dipoles (11, 12) is aligned with one of the first and second in-plane crystal axes (13, 14) and the waveguide is strained in an in-plane direction which is misaligned with the first and second in-plane crystal axes.

**4.** A photon source (1) according to claim 3, wherein the direction of strain is orientated at an angle which bisects the first and second in-plane crystal axes.

**5.** A photon source (1) according to any one of claims 1 to 4, wherein the quantum dot (2) comprises a first region of a first semiconductor material disposed in a second region of a second, different semiconductor material, the first region being sufficiently small to exhibit zero-dimensional confinement.

**6.** A photon source (1) according to any one of claims 1 to 4, wherein the quantum dot (2) comprises a dopant atom or molecule disposed in a region of undoped semiconductor material.

**7.** A photon source (1) according to any preceding claim, wherein the waveguide (3) comprises a photonic crystal.

**8.** A photon source (1) according to any preceding claim, wherein the waveguide (3) comprises a photonic wire.

**9.** Apparatus comprising:

  a photon source (1) according any one of claims 1 to 8; and
  a laser (41) configured to optically excite the quantum dot (2).

**10.** Apparatus comprising:

  a photon source (1) according any one of claims 1 to 8; and
  a circuit (43) configured to electrically excite the quantum dot (2).

**Patentansprüche**

**1.** Photonenquelle (1), umfassend einen Quantenpunkt (2), der in einem optischen Wellenleiter (3) eingebettet ist, wobei der Quantenpunkt einen ersten und zweiten Hell/Neutral-Anregungsdrehzustand (9, 10) mit einem ersten bzw. zweiten orthogonalen optischen Dipol (11, 12) aufweist, und wobei der optische Wellenleiter in einer Ebene liegt, kristallines Halbleitermaterial mit einer ersten und zweiten ebeneninternen Kristallachse (13, 14) umfasst und einen Wellenleitermodus (15) aufweist, **dadurch gekennzeichnet, dass** die Quelle konfiguriert ist, um den ersten und zweiten Drehzustand mit dem Wellenleitermodus zu koppeln, wobei der Wellenleiter (3) so ausgerichtet ist, dass die Polarisation des Wellenleitermodus bezüglich des ersten und zweiten optischen Dipols (11, 12) verschoben ist.

**2.** Photonenquelle (1) nach Anspruch 2, wobei der Wellenleiter (3) in einem Winkel ausgerichtet ist, der die erste und zweite ebeneninterne Kristallachse (13, 14) halbiert.

**3.** Photonenquelle (1) nach Anspruch 1 oder 2, wobei der Wellenleiter (3) so ausgerichtet ist, dass einer des ersten und zweiten optischen Dipols (11, 12) auf eine der ersten und zweiten ebeneninternen Kristallachse (13, 14) ausgerichtet ist und der Wellenleiter in einer ebeneninternen Richtung gespannt wird, die bezüglich der ersten und zweiten ebeneninternen Kristallachse verschoben ist.

**4.** Photonenquelle (1) nach Anspruch 3, wobei die Spannungsrichtung in einem Winkel ausgerichtet ist, der die erste und zweite ebeneninterne Kristallachse halbiert.

**5.** Photonenquelle (1) nach einem der Ansprüche 1 bis 4, wobei der Quantenpunkt (2) eine erste Region eines ersten Halbleitermaterials umfasst, das in einer zweiten Region eines zweiten, unterschiedlichen Halbleitermaterials angeordnet ist, wobei die erste Region ausreichend klein ist, um keine dimensionale Einschränkung aufzuweisen.

**6.** Photonenquelle (1) nach einem der Ansprüche 1 bis 4, wobei der Quantenpunkt (2) ein dotierendes Atom oder Molekül umfasst, das in einer Region undotierten Halbleitermaterials angeordnet ist.

**7.** Photonenquelle (1) nach einem der vorangehenden Ansprüche, wobei der Wellenleiter (3) photonisches Kristall umfasst.

**8.** Photonenquelle (1) nach einem der vorstehenden Ansprüche, wobei der Wellenleiter (3) einen photonischen Draht umfasst.

**9.** Vorrichtung, umfassend:

eine Photonenquelle (1) nach einem der Ansprüche 1 bis 8;
und einen Laser (41), der konfiguriert ist, um den Quantenpunkt (2) optisch anzuregen.

**10.** Vorrichtung, umfassend:

eine Photonenquelle (1) nach einem der Ansprüche 1 bis 8;
und eine Schaltung (43), die konfiguriert ist, um den Quantenpunkt (2) elektrisch anzuregen.

**Revendications**

**1.** Source de photons (1) comprenant un point quantique (2) incorporé dans un guide d'onde optique (3), ledit point quantique possédant des premier et second états de spin d'exciton neutre lumineux (9, 10) possédant des premier et second dipôles optiques orthogonaux (11, 12) respectivement et ledit guide d'onde optique se trouvant dans un plan, comprenant un matériau semi-conducteur cristallin possédant des premier et second axes cristallins dans le plan (13, 14) et possédant un mode de guide d'onde (15) **caractérisé en ce que** la source est conçue pour coupler les premier et second états de spin au mode guide d'onde, ledit guide d'onde (3) étant orienté de sorte que la polarisation du mode guide d'onde soit désalignée avec les premier et second dipôles optiques (11, 12).

**2.** Source de photons (1) selon la revendication 2, ledit guide d'onde (3) étant orienté selon un angle qui divise les premier et second axes cristallins dans le plan (13, 14).

**3.** Source de photons (1) selon la revendication 1 ou 2, ledit guide d'onde (3) étant orienté de sorte que l'un des premier et second dipôles optiques (11, 12) soit aligné avec l'un des premier et second axes cristallins dans le plan (13, 14) et ledit guide d'onde étant contraint dans une direction dans le plan qui est désalignée avec les premier et second axes cristallins dans le plan.

**4.** Source de photons (1) selon la revendication 3, ladite direction de déformation étant orientée selon un angle qui divise les premier et second axes cristallins dans le plan.

**5.** Source de photons (1) selon l'une quelconque des revendications 1 à 4, ledit point quantique (2) comprenant une première zone d'un premier matériau semi-conducteur disposée dans une seconde zone d'un second matériau semi-conducteur différent, la première zone étant suffisamment petite pour présenter un confinement de dimension nulle.

**6.** Source de photons (1) selon l'une quelconque des revendications 1 à 4, ledit point quantique (2) comprenant un atome ou une molécule dopante disposée dans une zone de matériau semi-conducteur non dopé.

**7.** Source de photons (1) selon l'une quelconque des revendications précédentes, ledit guide d'onde (3) comprenant un cristal photonique.

**8.** Source de photons (1) selon l'une quelconque des revendications précédentes, ledit guide d'onde (3) comprenant un fil photonique.

**9.** Appareil comprenant :

une source de photons (1) selon l'une quelconque des revendications 1 à 8 ;

et un laser (41) conçu pour exciter optiquement le point quantique (2).

**10.** Appareil comprenant :

une source de photons (1) selon l'une quelconque des revendications 1 à 8 ;
et un circuit (43) conçu pour exciter électriquement le point quantique (2).

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6728281 B1
- US 6956330 B2
- US 20030127608 A1
- US 7019333 B1

### Non-patent literature cited in the description

- **C. SANTORI et al.** Triggered single photons from a quantum dot. *Physical Review Letters,* 2001, vol. 86, 1502
- **Z. YUAN et al.** Electrically Driven Single-Photon Source. *Science,* 2002, vol. 295, 102
- **T. HEINDEL et al.** Electrically driven quantum dot-micropillar single photon source with 34% overall efficiency. *Applied Physics Letters,* 2010, vol. 96, 011107
- **M. T. BORGSTROM et al.** Optically Bright Quantum Dots in Single Nanowires. *Nano Letters,* 2005, vol. 5, 1439
- **M. T. BORGSTROM et al.** *PHYSICAL REVIEW X*
- **A. LAUCHT et al.** A Waveguide-Coupled On-Chip Single-Photon Source. *Physical Review X,* 2012, vol. 2, 011014
- **A. LAUCHT et al.** Broadband Purcell enhanced emission dynamics of quantum dots in linear photonic crystal waveguides. *Journal of Applied Physics,* 2012, vol. 112, 093520
- **T. LUND-HANSEN.** Experimental Realization of Highly Efficient Broadband Coupling of Single Quantum Dots to a Photonic Crystal Waveguide. *Physical Review Letters,* 2008, vol. 101, 113903
- **P. STEPANOV et al.** Quantum dot spontaneous emission control in a ridge waveguide. *Applied Physics Letters,* 2015, vol. 106, 041112
- **V. S. C. MANGA RAO ; S. HUGHES.** Single quantum-dot Purcell factor and $\beta$ factor in a photonic crystal waveguide. *Physical Review B,* 2007, vol. 75, 205437
- **LEE et al.** Cryogenic two-photon laser photolithography with SU-8. *Applied Physics Letters,* 2006, vol. 88, 143123
- **I. SOLLNER et al.** *Deterministic photon-emitter coupling in chiral photonic circuits,* 2014, vol. ArXiv, 1406-4295